(19) Europäisches Patentamt
European Patent Office
Office européen des brevets

(11) **EP 2 309 023 A1**

(12) **EUROPEAN PATENT APPLICATION**
published in accordance with Art. 153(4) EPC

(43) Date of publication:
**13.04.2011 Bulletin 2011/15**

(51) Int Cl.:
*C23C 16/50* (2006.01)     *C23C 16/455* (2006.01)
*H01L 21/205* (2006.01)     *H01L 31/04* (2006.01)

(21) Application number: **09802988.7**

(22) Date of filing: **29.07.2009**

(86) International application number:
**PCT/JP2009/063488**

(87) International publication number:
**WO 2010/013746 (04.02.2010 Gazette 2010/05)**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**
Designated Extension States:
**AL BA RS**

(30) Priority: **30.07.2008   JP 2008195813
26.11.2008   JP 2008300643
10.03.2009   JP 2009056541**

(71) Applicant: **Kyocera Corporation
Kyoto-shi
Kyoto 612-8501 (JP)**

(72) Inventors:
• **NIIRA, Koichiro
Higashiomi-shi
Shiga 527-8555 (JP)**

• **ITO, Norikazu
Higashiomi-shi
Shiga 527-8555 (JP)**
• **INABA, Sinichiro
Higashiomi-shi
Shiga 527-8555 (JP)**
• **MATSUI, Hiroshi
Higashiomi-shi
Shiga 527-8555 (JP)**

(74) Representative: **Witte, Weller & Partner
Phoenixbau
Königstrasse 5
70173 Stuttgart (DE)**

(54) **DEPOSITION FILM FORMING APPARATUS AND DEPOSITION FILM FORMING METHOD**

(57)     In order to form a high-quality Si-based film at high speed, for example, a deposited film forming device according to one aspect of the present invention includes: a chamber; a first electrode arranged in the chamber; and a second electrode arranged in the chamber and spaced a certain distance from the first electrode. The second electrode includes first and second supplying parts. The first supplying part supplies a first material gas and generates hollow cathode discharge. The second supplying part supplies a second material gas higher in decomposition rate than the first material gas.

FIG. 1

**Description**

Technical Field

The present invention relates to a deposited film forming device and a deposited film forming method for forming a deposited film on a base.

Background Art

A conventional deposited film forming device includes a chamber, a gas introducing path through which material gas is introduced into the chamber, a pair of electrodes arranged in the chamber, and a high-frequency electrode for applying high frequency to one of the electrodes as a pair. A base on which a deposited film is to be formed is placed on the other one of the electrodes as a pair. Material gas is excited and activated in the chamber to generate a reactive species, and part of the reactive species is deposited on the base, thereby forming a film. A deposited film forming device capable of forming a high-quality deposited film at high speed has been required as the aforementioned deposited film forming device (see for example patent literature 1).

Prior Art Document

Patent Literature

Patent literature 1: Japanese Patent Application Laid-Open No. 2002-237460

Summary of Invention

Problems to be Solved by the Invention

However, the conventional deposited film forming device finds difficulty in achieving high film forming speed while maintaining a film quality. It is assumed that an Si film is to be formed with $SiH_4$ gas and $H_2$ gas, for example. In this case, $SiH_4$ is likely to be decomposed excessively if $SiH_4$ and $H_2$ are decomposed in the same plasma space as a result of different decomposition rates of $SiH_4$ and $H_2$ gases, leading to reduction in film quality.
The present invention has been made based on the aforementioned background. The present invention is intended to provide a deposited film forming device and a deposited film forming method capable of forming a high-quality deposited film at high speed. The present invention is specifically intended to provide a deposited film forming device and a deposited film forming method suitably applied in forming Si-based films used in thin-film Si-based solar cells.

Means for Solving Problems

A deposited film forming device according to one aspect of the present invention includes:

a chamber:

a first electrode arranged in the chamber; and
a second electrode arranged in the chamber and spaced a certain distance from the first electrode, the second electrode comprising first and second supplying parts, the first supplying part supplying a first material gas and generating hollow cathode discharge, the second supplying part supplying a second material gas higher in decomposition rate than the first material gas.

A deposited film forming method according to one aspect of the present invention includes:

a step of preparing a first electrode, a second electrode spaced a certain distance from the first electrode and comprising first and second supplying parts, and a base;
a step of placing the base between the first and second electrodes;
a step of generating hollow cathode discharge in a first space within the first supplying part;
a step of supplying a first material gas to the first space;
a step of activating the first material gas in the first space;

a step of supplying the activated first material gas from the first space toward the base;
a step of generating glow discharge in a second space located between the first and second electrodes;
a step of supplying a second material gas higher in decomposition rate than the first material gas from the second supplying part toward the base; and
a step of activating the second material gas in the second space.

Effect of the Invention

The deposited film forming device and the deposited film forming method of the present invention are capable of depositing a high-quality film at high speed on the base. More specifically, activation and/or decomposition of the first material gas supplied from the first supplying part is accelerated in the first supplying part by high-density plasma as a result of hollow cathode discharge. Further, the second material gas supplied from the second supplying part and higher in decomposition rate than the first material gas is activated in the second space between the first and second electrodes, and is unlikely to be decomposed excessively. Thus, a high-quality deposited film can be formed.

Brief Description of Drawings

Fig. 1 schematically shows an embodiment of a deposited film forming device according to one aspect of the present invention, Fig. 1(a) is a partial sectional view, and Fig. 1(b) is an enlarged sectional view of part of a first supplying part;
Fig. 2 is an enlarged view of part of a second electrode shown in Fig. 1;
Fig. 3 schematically shows an embodiment of a deposited film forming device according to one aspect of the present invention, Fig. 3(a) is a partial sectional view, and Fig. 3(b) is an enlarged sectional view of part of a first supplying part;
Fig. 4 is an enlarged plan view showing exemplary shapes of first and second supplying parts;
Fig. 5 is a partial sectional view of an exemplary parallel-plate type deposited film forming device; and
Fig. 6 is a graph showing results of Example.

Mode(s) for Carrying Out the Invention

<Deposited Film Forming Device>

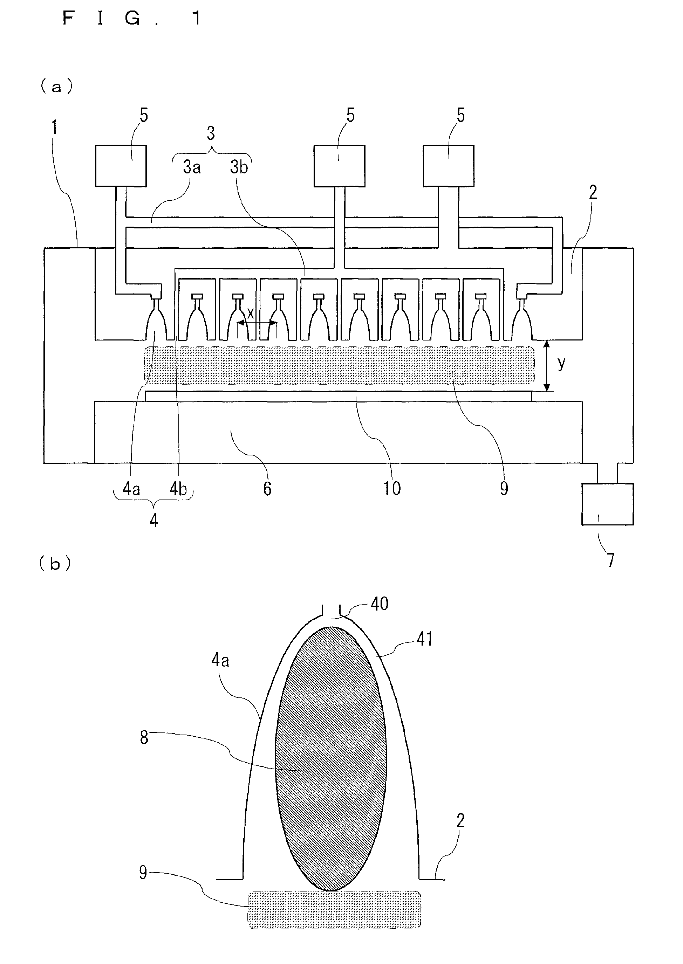

As shown in Figs. 1(a) and 1(b), a deposited film forming device of a first embodiment according to one aspect of the present invention includes: a chamber 1; a first electrode 6 arranged in the chamber 1; and a second electrode 2 arranged in the chamber 1 and spaced a certain distance from the first electrode 6. The second electrode 2 functions as a shower electrode, and includes first and second supplying parts 4a and 4b. The first supplying parts 4a supply a first material gas and generate hollow cathode discharge. The second supplying parts 4b supply a second material gas higher in decomposition rate than the first material gas. A base 10 on which a deposited film is to be formed is placed between the first and second electrodes 6 and 2. Unlike the illustration in the figure, the base 10 is not necessarily required to be supported on the first electrode 6, as long as it is placed between the first and second electrodes 6 and 2.
The second electrode 2 includes the first supplying parts 4a for supplying the first material gas, and the second supplying parts 4b for supplying the second material gas higher in decomposition rate than the first material gas. Each of the first supplying parts 4a includes a space (hereinafter called first space 8) for generating hollow cathode discharge. The second supplying parts 4b do not generate hollow cathode discharge, or generate discharge of a small magnitude. A second space 9 in which glow discharge is generated is located between the first and second electrodes 6 and 2. Hollow cathode discharge is a type of glow discharge, and is such that electrons are caused to move back and forth by electrostatic confinement enclosed, and the resultant energies of the electrons are used for producing plasma, thereby increasing a plasma density to a considerably high level.
The chamber 1 is a reaction container with reaction space capable of being vacuum sealed and which is defined at least by upper, side, and bottom walls. The interior of the chamber 1 is evacuated by a vacuum pump 7, and is regulated in pressure by a pressure regulator not shown.
The first electrode 6 has a function of an anode electrode, and includes a heater built into it that controls the temperature of the base 10. Accordingly, the first electrode 6 also functions as a temperature controlling mechanism of the base 10. For example, the temperature of the base 10 is controlled to range from 100 to 400°C, more preferably from 150 to 350°C.
The base 10 may be a flat plate made of a glass substrate and the like, or may be a film made of a metallic material, resin, or the like.
The second electrode 2 is opposite the first electrode 6, and functions as a cathode electrode. The second electrode 2 includes supplying units 4 for supplying gas introduced through a plurality of introducing paths 3 to the second space 9. The supplying units 4 are opened toward the base 10. The supplying units 4 each include the first supplying part 4a of a shape that generates hollow cathode discharge, and the second supplying part 4b that does not generate hollow cathode discharge, or generates hollow cathode discharge of a small magnitude. A difference between magnitudes of generated hollow cathode discharge can be evaluated in terms of visually recognized discharge intensity, or in terms of sectional area and depth of the opening of the supplying units 4.

As shown in Fig. 1(b), the first supplying part 4a is connected to an introducing path 3 a through which the first material gas is introduced from outside of the chamber 1, and includes a hollow portion 41. Numeral 40 in the figure shows a gas outlet.

The plurality of supplying units 4 are coupled through the plurality of introducing paths 3 to a plurality of gas cylinders not shown in which respective gases are stored. Basically, gases introduced through the first and second introducing paths 3a and 3b do not mix with each other until they reach the second space 9 after passing through the first and second supplying parts 4a and 4b. However, as described later, the first material gas passing through the first introducing path 3a is divided, and part of the first material gas is caused to flow through the second introducing path 3b (to mix with the second material gas) in some cases.

The decomposition rate of gas is defined as $e \times p\,(-\Delta Ea/kTe) \times Ng \times Ne \times ve \times \sigma g$. Here, $\Delta Ea$ is the excitation and activation energy (dissociation energy) of material gas, $k$ is the Boltzmann constant, $Te$ is an electron temperature, $Ng$ is a material gas concentration, $Ne$ is an electron concentration, $ve$ is an electron speed, and $\sigma g$ is the collision cross section of the material gas. At this time, $e \times p\,(-\Delta Ea/kTe)$ indicates a decomposition probability. The mathematical expression $e \times p\,(-\Delta Ea/kTe) \times \delta g$ may also be expressed as $\sigma\,(Ea)$.

The first material gas is supplied from the first supplying parts 4a after passing through the first introducing path 3a. The second material gas is supplied from the second supplying parts 4b after passing through the second introducing path 3b. The first material gas is activated in the first spaces 8 of the first supplying parts 4a in which hollow cathode discharge is generated, and is further activated in the second space 9. The second material gas is activated in the second space 9.

The hollow portions 41 of the first supplying parts 4a of the second electrode 2 are shaped for example into a tapered or staircase shape where the sectional area of a plane vertical to the axis in the depth direction becomes smaller with a greater depth, namely the sectional area becomes smaller with a greater distance from the first electrode 6. This allows generation of hollow cathode discharge at any depth in the hollow portion 41 in response to the magnitude of ambient pressure in discharge space. The second supplying parts 4b of the second electrode 2 may be shaped into a pattern where the sectional area of a plane vertical to the axis in the depth direction is constant regardless of a depth. Or, in contrast to the first supplying parts 4a, the second supplying parts 4b may be shaped into a tapered or staircase shape where the sectional area becomes greater with a greater distance from the first electrode 6.

The first and second material gases are suitably selected according to the type of a deposited film. As an example, in order to form an Si-based thin film made of a-Si: H (hydrogenated amorphous silicon) or $\mu$c-Si:H (hydrogenated microcrystalline silicon), non-Si-based gas and Si-based gas may be used as the first and second material gases respectively. Examples of the non-Si-based gas include hydrogen ($H_2$) gas. Examples of the Si-based gas include silane ($SiH_4$) gas, disilane ($Si_2H_6$) gas, silicon tetrafluoride ($SiF_4$) gas, silicon hexafluoride ($Si_2F_6$) gas, and dichlorosilane ($SiH_2Cl_2$) gas. If doping gas is to be introduced, examples of a p-type doping gas include diborane ($B_2H_6$) gas, and examples of an n-type doping gas include phosphine ($PH_3$) gas. The first or second introducing path 3a or 3b may be selected as appropriate as an introducing path of the doping gas. However, if a heated catalyzer 11 is provided in the first introducing path 3a like in a deposited film forming device of a second embodiment described later, introduction through the second introducing path 3b is preferred.

The deposited film forming device of the first embodiment of the aforementioned structure is capable of accelerating decomposition of the first material gas by high-density plasma as a result of hollow cathode discharge. The second material gas is supplied mainly from the second supplying parts 4b that do not generate hollow cathode discharge, and is excited and activated by plasma in the second space 9 smaller than the plasma density of the first spaces 8. As a result, a high-quality thin film is formed at high speed without causing excessive decomposition of the second material gas.

In particular, as a result of use of Si-based gas such as $SiH_4$ gas as the second material gas, much of the $SiH_4$ gas supplied into the chamber 1 is decomposed by plasma in the second space 9. This suppresses excessive decomposition of the $SiH_4$ gas, thereby suppressing generation of $SiH_2$, SiH, and Si other than $SiH_3$ that exert adverse effect on a film quality. As a result, a high film quality is achieved. Further, accelerating decomposition of hydrogen gas as the first material gas by high-density plasma in the first spaces 8 makes it possible to form a film at high speed while maintaining crystallinity and a film quality.

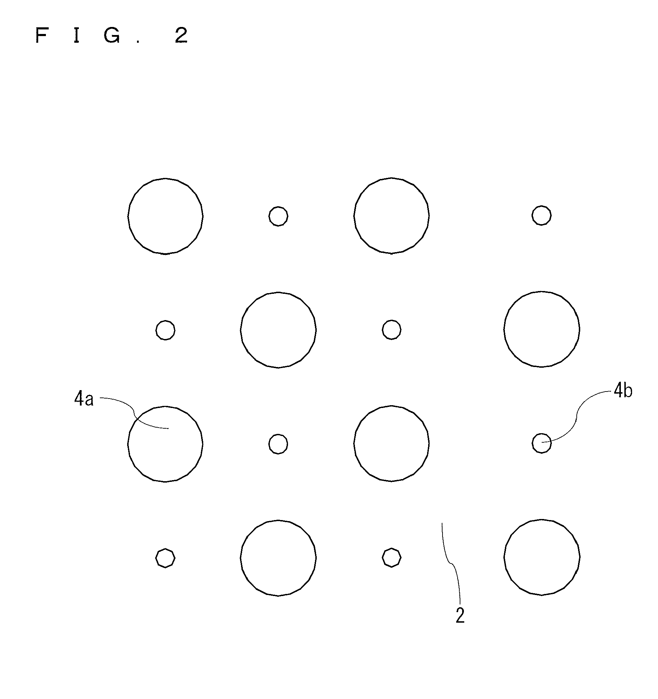

As shown in Fig. 2, the arrangement of the plurality of supplying units 4 may be such that the first and second supplying parts 4a and 4b are alternately placed in a regular pattern. This is not the only pattern, but various other patterns are applicable.

The numbers of the first and second supplying parts 4a and 4b may be different. If the gas flow rates of the first and second material gases are different, for example if the gas flow rate of the first material gas is greater than that of the second material gas, the number of the first supplying parts 4a may be made larger than that of the second supplying parts 4b. This keeps a supply balance while reducing variations in film thickness and film quality.

The second electrode 2 includes the plurality of first supplying parts 4a. As shown in Fig. 1(a), a distance x between two adjacent ones of the first supplying parts 4a (distance between the central axes of the hollow portions 41) is smaller than a distance y between the second electrode 2 and the base 10. This reduces variations in thickness and film quality of films to be formed.

The introducing paths 3 may directly be connected to the corresponding cylinders, or may be coupled to a gas controller for controlling the flow rate, flow speed, temperature and the like of gas. A buffer area may be provided. In this case, gases supplied from the cylinders are mixed in the buffer area, and thereafter mixed gas is supplied from the supplying units 4 after passing through the introducing paths 3.

High-frequency power sources 5 are connected to the second electrode 2, and may supply a frequency of from about 13.56 MHz to about 100 MHz. When a film to be formed has a large area of about $1m^2$ or more, a frequency of about 60 MHz or lower is preferably used. Applying electric power from the high-frequency power sources 5 to the second electrode 2 generates plasma in the second space 9 between the second electrode 2 and the base 10, and higher density plasma in the first spaces 8 inside the hollow portions 41 of the first supplying parts 4a.

Use of a dry-system vacuum pump such as a turbo-molecular pump is desirably used as the vacuum pump 7 in order to prevent mixture of impurities from a vacuum system into a film. The least ultimate vacuum is $1 \times 10^{-3}$ Pa or less, and is preferably no more than $1 \times 10^{-4}$ Pa. Pressure to be applied during film formation is from 50 to 7000 Pa, although varied depending on the type of a film to be formed.

The deposited film forming device may include a plurality of film forming chambers. As an example, film forming chambers for forming p-type, i-type, and n-type films are provided in order to form a thin-film solar cell element. In this case, at least one of these film forming chambers may be of the aforementioned structure. More specifically, applying the aforementioned structure to the film forming chamber for forming an i-type film required to be thick and to have high quality enhances productivity, and provides a thin-film solar cell with a high conversion efficiency.

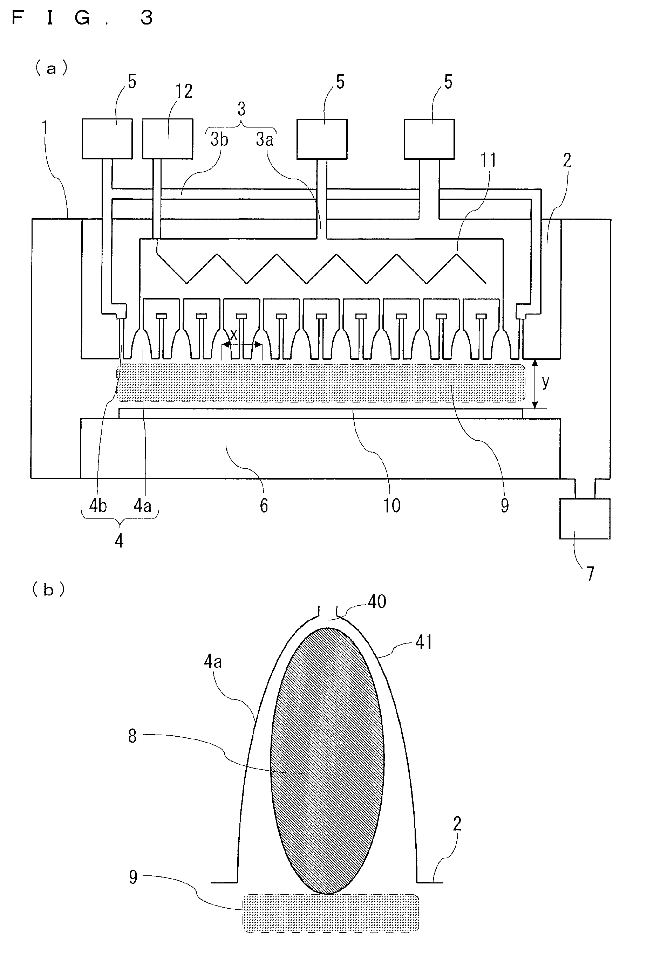

A deposited film forming device of a second embodiment is described next. As shown in Fig. 3, the deposited film forming device of the second embodiment includes: a first electrode 6 arranged in a chamber 1 and which supports a base 10 on which a deposited film is to be formed; and a second electrode 2 spaced a certain distance from the first electrode 6 while opposite the first electrode 6. The second electrode 2 includes: first supplying parts 4a for supplying a first material gas and for generating hollow cathode discharge; second supplying parts 4b for supplying a second material gas higher in decomposition rate than the first material gas, while generating no hollow cathode discharge or generating hollow cathode discharge of a small magnitude; a first introducing path 3a connected to the first supplying parts 4a; and a heated catalyzer 11 provided in the first introducing path 3a. The heated catalyzer 11 is connected to a power source 12 for heating provided outside the chamber 1.

Those parts shared with the first embodiment are not described below.

The first material gas is heated and activated with the heated catalyzer 11 heated up to a temperature of from about 500 to 2000°C. The first material gas is further activated in the first spaces 8 of the first supplying parts 4a in which hollow cathode discharge is generated, and in the second space 9 that becomes plasma space.

The heated catalyzer 11 functions as a heated catalyzer that increases the temperature of a medium by heating by causing a current to flow in the medium, thereby causing excitation and activation (decomposition) of gas contacting the medium. The heated catalyzer 11 is made of a metallic material at least on a surface thereof. The metallic material is preferably and desirably pure metal or an alloy material containing at least one of Ta, W, Re, Os, Ir, Nb, Mo, Ru, and Pt that are high melting point metallic materials. The shape of the heated catalyzer 11 is defined for example by forming the aforementioned metallic material into a wire, a plate, or a mesh.

Before being used for film formation, the heated catalyzer 11 is preliminarily heated for several minutes or more at a temperature higher than that of film formation. This suppresses doping of impurities in the metallic material of the heated catalyzer 11 into a film during film formation.

The deposited film forming device of the second embodiment of the aforementioned structure is capable of accelerating decomposition of the first material gas by heating with the heated catalyzer 11. The first material gas that has not been decomposed, or the first material gas recombined after being decomposed increases in temperature. This further accelerates gas decomposition by high-density plasma as a result of hollow cathode discharge. The second material gas is supplied from the second supplying parts 4b that do not generate hollow cathode discharge, and is excited and activated by plasma in the second space 9 smaller than the plasma density of the first spaces 8. As a result, a high-quality thin film is formed at high speed without causing excessive decomposition of the second material gas.

<Deposited Film Forming Method>

A deposited film forming method of the first embodiment includes: a step of preparing the first electrode 6, the second electrode 2 spaced a certain distance from the first electrode 6 and comprising the first and second supplying parts 4a and 4b, and the base 10; a step of placing the base 10 between the first and second electrodes 6 and 2; a step of generating hollow cathode discharge in the first spaces 8 within the first supplying parts 4a; a step of supplying the first material gas to the first spaces 8; a step of activating the first material gas in the first spaces 8; a step of supplying the activated first material gas from the first spaces 8 toward the base 10; a step of generating glow discharge in the second space 9 located between the first and second electrodes 6 and 2; a step of supplying the second material gas higher in decomposition rate than the first material gas from the second supplying parts 4b toward the base 10; and a step of activating the second material gas in the second space 9. The first and second material gases activated by following these steps are mixed in the second space 9, and a component of the material gases is deposited on the base 10, thereby forming a deposited film on the base 10.

In the above-described steps, the base 10 is transported by a transport mechanism and the like not shown, transferred onto the first electrode 6, and then held on the first electrode 6.

In the above-described steps, the first material gas is excited and activated in the first spaces 8 of the first supplying parts 4a and in the second space 9, and the second material gas is excited and activated in the second space 9. This accelerates activation of the first material gas further, and suppresses excessive decomposition of the second material gas.

In the above-described steps, supplying the second material gas only from the second supplying parts 4b results in decomposition of the second material gas only in the second space 9. This especially suppresses excessive decomposition of the second material gas further.

Also, supplying the first material gas only from the first supplying parts 4a accelerates decomposition of the first material gas further by high-density plasma in the first spaces 8.

In order to form a hydrogenated amorphous silicon film, $H_2$ and $SiH_4$ gases are supplied to the first and second introducing paths 3a and 3b respectively. Further, a gas pressure may be set to range from 50 to 700 Pa, a gas flow rate ratio $H_2/SiH_4$ may be set to range from 2/1 to 40/1, and a high-frequency power density may be set to range from 0.02 to 0.2 W/cm$^2$. In the case of a thin-film solar cell with a pin junction including an i-type amorphous silicon film, the thickness of the i-type amorphous silicon film may be set to range from 0.1 to 0.5 $\mu$m, preferably from 0.15 to 0.3 $\mu$m.

In order to form a hydrogenated microcrystalline silicon film, $H_2$ and $SiH_4$ gases are supplied to the first and second introducing paths 3a and 3b respectively. Further, a gas pressure may be set to range from 100 to 7000 Pa, a gas flow rate ratio $H_2/SiH_4$ may be set to range from 10/1 to 200/1, and a high-frequency power density may be set to range from 0.1 to 1 W/cm$^2$. In the case of a thin-film solar cell with a pin junction including an i-type microcrystalline silicon film, the thickness of the i-type microcrystalline silicon film may be set to range from 1 to 4 $\mu$m, preferably from 1.5 to 3 $\mu$m, and the degree of crystallization may be set at about 70%.

The forming method of the first embodiment more efficiently produces atomic hydrogen as a result of decomposition of hydrogen gas. This accelerates crystallization of a microcrystalline silicon film, thereby forming a film at high speed. This also suppresses excessive decomposition of $SiH_4$ gas, thereby forming a high-quality film.

The flow rate of $SiH_4$ gas is considerably smaller than that of $H_2$ gas during formation of a hydrogenated microcrystalline silicon film, compared to that during formation of a hydrogenated amorphous silicon film. So, the number of the second supplying parts 4b is made smaller than the number of the first supplying parts 4a, or the diameter of the opening of the second supplying parts 4b is made smaller. This increases a gas pressure in the second introducing path 3b, so that $SiH_4$ gas is pumped uniformly from the plurality of supplying parts 4b. Further, $H_2$ gas supplied to the first introducing path 3a may be divided, and the divided part of $H_2$ gas may be supplied to the second introducing path 3b. In this case, the total flow of gas supplied from the second supplying parts 4b is increased, thereby increasing a gas pressure (total pressure) in the second introducing path 3b. As a result, $SiH_4$ gas is pumped uniformly from the plurality of supplying parts 4b.

If $H_2$ gas (first material gas) is divided, and the divided part of $H_2$ gas is supplied to the second introducing path 3b, the flow rate of $H_2$ gas supplied to the second introducing path 3b is controlled such that a pressure difference between an upstream pressure $P_{in}$ and a downstream pressure $P_{out}$ of the second supplying parts 4b is defined as $P_{in} - P_{out} \geq 302$ Pa. Here, the upstream pressure means a pressure at the inlets of the second supplying parts 4b, and the downstream pressure means a pressure at the outlets of the second supplying parts 4b. Divided part of $H_2$ gas is supplied to the second introducing path 3b in a way that satisfies the aforementioned relational expression, so that variations in film thickness and film quality are reduced further. Supplying more $H_2$ gas to the first introducing path 3a than that supplied to the second introducing path 3b makes it possible to maintain atomic hydrogen at a necessary amount produced as a result of decomposition of $H_2$ gas.

The following relational expression is established among a gas supply amount Q (Pa·M$^3$/S), a conductance C (m$^3$/s), and a pressure difference $\Delta$P (Pa) at the second supplying parts 4b:

$$Q = C \times \Delta P \qquad (1)$$

$P_{in}$ is calculated from the gas supply amount Q to the second supplying parts 4b and the conductance C of the second supplying parts 4b by using the Expression (1) and the aforementioned relationship $\Delta P = P_{in} - P_{out}$. However, the conductance C of the second supplying parts 4b differs according to the shape of the second supplying parts 4b. So, the calculation is explained by using an example. A gas flow includes a viscous flow and a molecular flow. In the description below, a viscous flow is considered as a dominant gas flow.

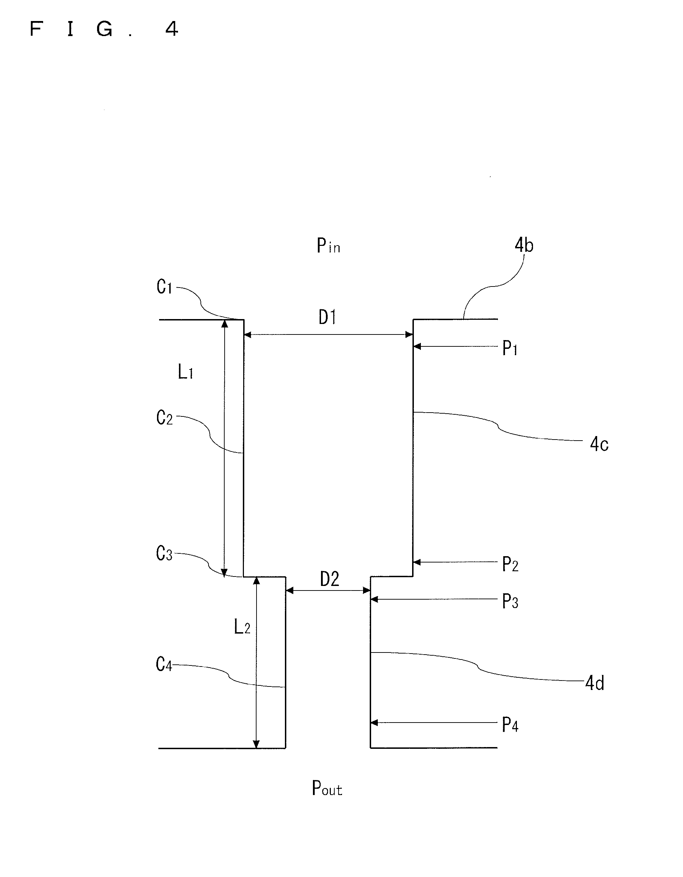

As shown in Fig. 4, the second supplying parts 4b have a shape defined by combining holes of two different diameters. The conductance C of the second supplying parts 4b is defined by combining an orifice conductance $C_1$ ($m^3$/s) at the inlet portion of a first hole 4c, a conductance $C_2$ ($m^3$/s) of the first hole 4c, a conductance $C_3$ ($m^3$/s) at the junction between first and second holes 4c and 4d, and a conductance $C_4$ ($m^3$/s) of the second hole 4d.

$$1/C = 1/C_1 + 1/C_2 + 1/C_3 + 1/C_4 \qquad (2)$$

In the below, the upstream and downstream pressures of the first hole 4c are expressed as $P_1$ (Pa) and $P_2$ (Pa), the upstream and downstream pressures of the second hole 4d are expressed as $P_3$ (Pa) and $P_4$ (Pa), the respective diameters of the first and second holes 4c and 4d are expressed as $D_1$ and $D_2$ (m), the respective areas of the openings of the first and second holes 4c and 4d are expressed as $A_1$ and $A_2$ ($m^2$), and the respective lengths of the first and second holes 4c and 4d are expressed as $L_1$ and $L_2$ (m). Relational expressions applied to calculate the upstream pressure $P_{in}$ of the second supplying parts 4b are described next.

The flow rate Q (Pa $\times$ $m^3$/s) of mixed gas of $SiH_4$ and $H_2$ gases supplied to the second introducing path 3b, a molecular weight M (kg/mol), and a coefficient of viscosity V (Pa·s) are obtained from the respective flow rates $Q_1$ and $Q_2$ of $SiH_4$ and $H_2$ gases, molecular weights $M_1$ and $M_2$ of $SiH_4$ and $H_2$ gases, and coefficients of viscosity $V_1$ and $V_2$ of $SiH_4$ and $H_2$ gases, and are expressed as follows. In the following, d shows a rate of content of $H_2$ gas in the mixed gas.

$$Q = (Q_1 + Q_2)/n \qquad (3)$$

Where

$$d = Q_2/(Q_1 + Q_2) \qquad (4)$$

$$M = (1 - d)\, M_1 + dM_2 \qquad (5)$$

$$V = (1 - d)\, V_1 + dV_2 \qquad (6)$$

Next, the conductance $C_4$ of the second hole 4d is defined by the following relational expression:

$$C_4 = \pi \times D_2{}^4/(128 \times V \times L_2) \times (P_3 + P_4)/2 \qquad (7)$$

where

$$Q = C_4 \times (P_3 - P_4) \qquad (8)$$

A downstream pressure $P_4$ of the second hole 4d is the same as the second downstream pressure $P_{out}$ that is a gas pressure inside the chamber 1. Thus, an upstream pressure $P_3$ of the second hole is calculated from Expressions (3), (4), (6), (7), and (8).

Next, the conductance $C_3$ at the junction between the first and second holes 4c and 4d is defined by the following relational expressions:

$$C_3 = A_1 \times A_2/(A_1 - A_2) \times v/4 \quad (9)$$

where

$$v = (8RT/\pi M)\ 1/2 \quad (10)$$

$$Q = C_3 \times (P_2 - P_3) \quad (11)$$

Here, v(m/s) is an average speed of a gas molecule, T (K) is a temperature, and R (J/K/mol) is a gas constant.

A downstream pressure $P_2$ of the first hole 4c is calculated from Expressions (3), (4), (5), (9), (10), and (11), from the upstream pressure $P_3$ of the second hole 4d, and from the temperature $_T$.

Next, the conductance $C_2$ of the first hole 4c is defined by the following relational expressions:

$$C_2 = \pi \times D_1^4/(128 \times V \times L_1) \times (P_1 + P_2)/2 \quad (12)$$

where

$$Q = C_2 \times (P_1 - P_2) \quad (13)$$

Accordingly, an upstream pressure $P_1$ of the first hole 4c is calculated from Expressions (3), (4), (6), (12), and (13), and from the downstream pressure $P_2$ of the first hole 4c.

Finally, the orifice conductance $C_1$ of the first hole 4c is defined by the following relational expressions:

$$C_1 = A_1 \times v/4 \quad (14)$$

where

$$Q = C_1 \times (P_{in} - P_1) \quad (15)$$

Accordingly, the upstream pressure $P_{in}$ of second supplying parts is calculated from Expressions (3), (4), (5), (10), (14), and (15), from the upstream pressure $P_1$ of the first hole 4c, and from the temperature $_T$.

In addition to the steps of the first embodiment, a deposited film forming method of the second embodiment includes: a step of placing the base 10 between the first and second electrodes 6 and 2; a step of applying high-frequency power to the second electrode 2; a step of supplying the first material gas to the first spaces 8; a step of activating the first material gas with the heated catalyzer 11 in the first introducing path 3a connected to the first supplying parts 4a; a step of activating the first material gas in the first spaces 8; a step of supplying the second material gas to the second space 9; and a step of activating the second material gas in the second space 9 located between the first and second electrodes 6 and 2. The first and second material gases activated by following these steps are mixed in the second space 9, and a component of the material gases is deposited on the base 10, thereby forming a high-quality deposited film at high speed on the base 10.

The first material gas is heated with the heated catalyzer 11 in the first introducing path 3a, and is supplied only from the first supplying parts 4a. Thus, decomposition of the first material gas is accelerated further by the heated catalyzer 11, and by high-density plasma in the first spaces 8.

In the forming method of the second embodiment, hydrogen gas (first material gas) heated with the heated catalyzer 11 is supplied to plasma space (second space 9). Thus, resultant gas heating effect suppresses reaction of higher-order silane formation in the plasma space (second space 9). The reaction of higher-order silane formation mentioned here is reaction of formation of polymeric gas as a result of $SiH_2$ insertion reaction expressed by the following 1) and 2), and the similar $SiH_2$ insertion reaction following 1) and 2):

1)

$$SiH_4 + SiH_2 \rightarrow Si_2H_6$$

2)

$$Si_2H_6 + SiH_2 \rightarrow Si_3H_8$$

$SiH_2$ is generated together with $SiH_3$ that becomes the main component of a film to be formed by collision of $SiH_4$ with electros in plasma. More $SiH_2$ is generated as plasma power is increased especially for increasing speed of film formation, thereby forming more higher-order silane molecules. Resultant higher-order silane molecules disturb deposition reaction (film growth reaction) on a surface of a film being formed if attached to the surface of the film, thereby worsening a film quality. If taken into the film, these higher-order silane molecules also disturb a film structure, thereby worsening a film quality.

The aforementioned reaction of higher-order silane formation is recognized as exothermal reaction that proceeds with discharge of heat generated as a result of the reaction to the environment. However, if the environment (more specifically, the environment mainly containing hydrogen gas) is already heated as a result of the gas heating effect described above, exothermal reaction cannot be discharged easily to the environment. This makes the progress of the reaction of higher-order silane formation as exothermal reaction difficult. As a result, a high-quality silicon film is formed even under condition of high-speed film formation with large plasma power.

The forming method of the second embodiment may more efficiently produce atomic hydrogen as a result of decomposition of hydrogen gas. This accelerates crystallization of a microcrystalline silicon film, thereby forming a high-quality microcrystalline silicon film even at high speed.

If the first material gas supplied to the first introducing path 3a is divided, the divided part is supplied to the second introducing path 3b, and thus the amount of the first material gas passing through the first introducing path 3a is small, decomposition of the first material gas is accelerated satisfactorily by heating with the heated catalyzer 11 and by high-density plasma in the first spaces 8. As a result, a high-quality deposited film is formed on the base 10 at satisfactorily high speed.

In order to form an SiC-based wide gap film such as a-SiC (amorphous silicon carbide), $H_2$ and $SiH_4$ gases are supplied to the first introducing path 3a, and silane ($SiH_4$) gas is supplied to the second introducing path 3b. Further, a gas pressure may be set to range from 100 to 700 Pa, and a high-frequency power density may be set to range from 0.01 to 0.1 W/cm$^2$. An SiC-based wide gap film is applied as a window layer of a solar cell on the side of light incidence. In the case for example of a thin-film solar cell with a pin junction including a p-type amorphous silicon carbide film, the thickness of the p-type amorphous silicon carbide film may be set to range from 0.005 to 0.03 $\mu$m, preferably from 0.01 to 0.02 $\mu$m. $CH_4$ gas has a small deposition rate, so it generally has low decomposition efficiency. In response, gas decomposition is accelerated by high-density plasma in the first spaces 8, so $CH_4$ gas is efficiently decomposed. As a result, a high-quality SiC-based wide gap film is formed at high speed. An SiC-based wide gap film is also applicable as a photoactive layer (i-type layer).

Next, in order to form an SiGe-based narrow gap film such as a-SiGe (amorphous silicon germanium), $H_2$ and $SiH_4$ gases are supplied to the first introducing path 3a, and Ge-based gas such as $GeH_4$ gas is supplied to the second introducing path 3b. Further, a gas pressure may be set to range from 100 to 700 Pa, and a high-frequency power density may be set to range from 0.01 to 0.2 W/cm$^2$. An SiGe-based narrow gap film is used to absorb light of a long wavelength that cannot be absorbed by an Si film. In the case of a thin-film solar cell with a [a-Si/a-SiGe/$\mu$c-Si] type triple junction including an i-type amorphous silicon germanium film, the thickness of the i-type amorphous silicon germanium film may be set to range from 0.1 to 0.5 $\mu$m, preferably from 0.15 to 0.3 $\mu$m. In the case of a thin-film solar cell with a [a-Si/$\mu$c-Si/$\mu$c-SiGe] type triple junction including an i-type microcrystalline silicon germanium film, the thickness of the i-type microcrystalline silicon germanium film may be set to range from 1 to 4 $\mu$m, preferably from 1.5 to 3 $\mu$m. $GeH_4$ gas is higher in decomposition rate than $SiH_4$ gas. So, $GeH_4$ gas may be supplied from the second supplying parts 4b, and then may be decomposed in the second space 9. Further, $SiH_4$ gas may be supplied from the first supplying parts 4a, and then may be decomposed by high-density plasma in the first spaces 8. Thus, balance between the decomposition rates of $SiH_4$ and $GeH_4$ gases is optimized, so that a high-quality SiGe-based narrow gap film is formed at high speed. At this time, reducing a high-frequency power density to a level lower than that applied during formation of an amorphous silicon film or a microcrystalline silicon film makes it possible to lower the plasma density of the first spaces 8 to a level approximately the same as that of the second space 9 during formation of an a-Si film or a $\mu$c-Si film. The plasma density of the second space 9 can also be reduced to a level lower than that during formation of an a-Si film or a $\mu$c-Si film. Thus, excessive decomposition of $SiH_4$ gas is suppressed that may result in generation of $SiH_2$, SiH, and Si other than $SiH_3$ that exert adverse effect on a film quality. Excessive decomposition of $GeH_4$ gas is also suppressed. As a result, a high-quality film is provided.

A thin-film solar cell formed by the aforementioned method includes a high-quality film formed at high speed, so that a solar cell with enhanced productivity and with a high conversion efficiency is provided. As an example, such a thin-film solar cell is of a tandem structure where semiconductor composed of an amorphous silicon film and semiconductor composed of a microcrystalline silicon film are stacked from the side of a light receiving surface. As another example, the thin-film solar cell is of a triple structure where semiconductor composed of an amorphous silicon film, semiconductor composed of an amorphous silicon germanium film, and semiconductor composed of a microcrystalline silicon film are stacked. The thin-film solar cell may also be of a triple structure where semiconductor composed of an amorphous silicon film, semiconductor composed of a microcrystalline silicon film, and semiconductor composed of a microcrystalline silicon germanium film are stacked. At least one of the aforementioned semiconductors may be formed by the method described above.

Example 1

Supply of $H_2$ gas (first material gas) only to the first supplying parts 4a, and separate supply of $H_2$ gas (first material gas) to the first and second supplying parts 4a and 4b were compared.

A tandem thin-film solar cell was formed. The solar cell includes, from bottom to top, a glass substrate with a transparent conductive film on its surface, a photoelectric conversion layer with a pin junction composed of amorphous silicon films, a photoelectric conversion layer with a pin junction composed of microcrystalline silicon films, and a back electrode. The thickness of the i-type amorphous silicon film was set at 2500 Å, and the thickness of the i-type microcrystalline silicon film was set at 2.8 $\mu$m.

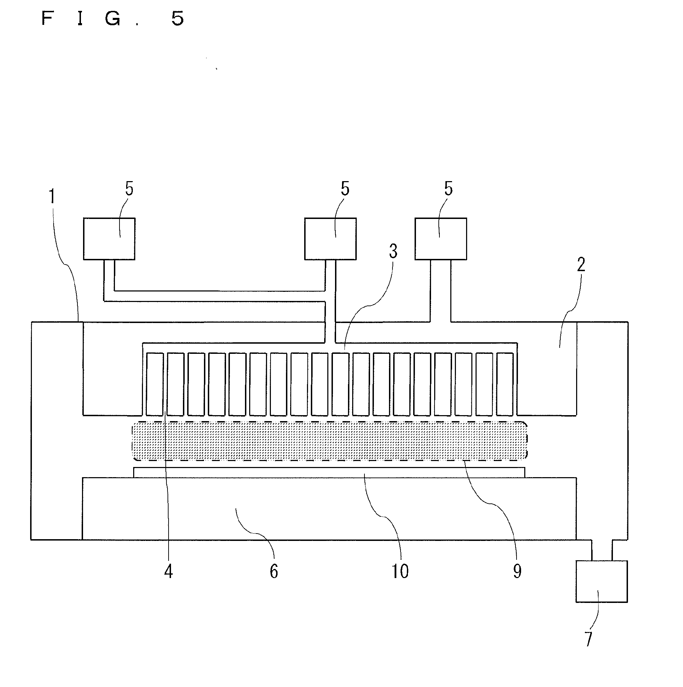

The photoelectric conversion layer composed of the amorphous silicon films, and the p-type and n-type microcrystalline silicon films were formed by a generally used parallel-plate deposited film forming device shown in Fig. 5. Constituent elements in Fig. 5 that are the same as those in Fig. 1(a) are identified by the same numerals. In the figure, numeral 2 shows a generally used shower electrode.

The i-type microcrystalline silicon film was formed by the deposited film forming device shown in Fig. 1 that generates hollow cathode discharge. The shape of the second supplying parts 4b is defined by combining holes of two different diameters as shown in Fig. 4. The diameter $D_1$ of the first hole 4c was defined as $D_1 = 5 \times 10^{-4}$ m (= 500 $\mu$m), and the diameter $D_2$ of the second hole 4d was defined as $D_2 = 3 \times 10^{-4}$ m (= 300 $\mu$m). The length $L_1$ of the first hole 4c was defined as $L_1 = 1 \times 10^{-2}$ m (= 10 mm), and the length $L_2$ of the second hole 4d was defined as $L_2 = 3 \times 10^{-3}$ m (= 3 mm). Further, 188 supplying parts 4b were prepared.

The i-type microcrystalline silicon film was formed under the following condition. Gas pressure in the chamber 1 was defined as $P_{out} = 1333$ Pa (10 Torr), a gas temperature was defined as T = 293 K (20°C), and the heating temperature of a base was set at 240°C. Further, the supply amount of $SiH_4$ gas to be introduced in the chamber 1 was defined as $Q_1 = 1.89 \times 10^{-2}$ Pa·m³/S (= 12 sccm), and the supply amount of $H_2$ gas to be introduced in the chamber 1 was set at $9.44 \times 10^{-1}$ Pa·m³/s (= 600 sccm). In addition, the molecular weights of $SiH_4$ and $H_2$ gases were defined as $M_1 = 3.21 \times 10^{-3}$ kg/mol and $M_2 = 2.02 \times 10^{-3}$ kg/mol respectively, and coefficients of viscosity thereof were defined as $V_1 = 8.92 \times 10^{-6}$ Pa·s and $V_2 = 1.18 \times 10^{-5}$ Pa·s respectively.

$SiH_4$ gas was all introduced through the second supplying parts 4b into the chamber, and $H_2$ gas was introduced separately to the first and second supplying parts 4a and 4b, thereby forming the i-type microcrystalline silicon film. Then, 16 thin-film solar cell elements of 1 cm × 1 cm were formed on a glass substrate of 10 cm × 10 cm.

The supply amount $Q_2$ of $H_2$ gas supplied from the second supplying parts 4b was changed, and resultant nonuniformity in power generation efficiency of a thin-film solar cell was evaluated. Nonuniformity in power generation efficiency of a thin-film solar cell in the case of supply of $H_2$ gas only to the first supplying parts 4a was also evaluated as Comparative Example. Nonuniformity in power generation efficiency is expressed as $((E_{Max} - E_{Min})/(E_{Max} + E_{Min})) \times 100(\%)$, where $E_{Max}$ is the maximum power generation efficiency, and $E_{Min}$ is the minimum power generation efficiency.

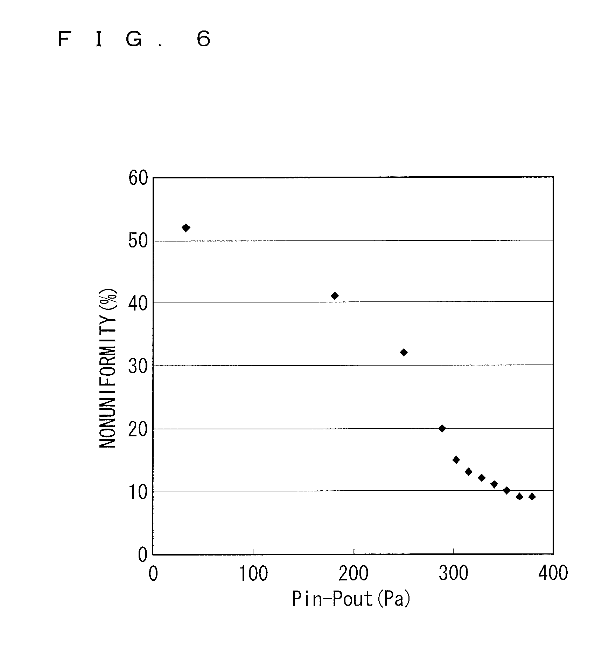

The results obtained under the respective conditions are shown in Table 1 and Fig. 6.

[Table 1]

| No. | Q2 (Pa·m³/s) | Pin (Pa) | Pin-Pout (Pa) | NONUNIFORMITY(%) |
|---|---|---|---|---|
| 1 | 0.000 | 1365 | 32 | 52 |
| 2 | 0.157 | 1514 | 181 | 41 |
| 3 | 0.236 | 1583 | 250 | 32 |
| 4 | 0.283 | 1622 | 289 | 20 |
| 5 | 0.299 | 1635 | 302 | 15 |
| 6 | 0.315 | 1648 | 315 | 13 |
| 7 | 0.330 | 1661 | 328 | 12 |
| 8 | 0.346 | 1674 | 341 | 11 |
| 9 | 0.362 | 1687 | 354 | 10 |
| 10 | 0.378 | 1700 | 367 | 9 |
| 11 | 0.393 | 1712 | 379 | 9 |

As seen from Table 1 and Fig. 6, Nos. 2 to 11 corresponding to the cases where the i-type microcrystalline silicon film was formed by supplying $H_2$ gas separately to the first and second supplying parts 4a and 4b corrected nonuniformity in power generation efficiency of a thin-film solar cell, compared to No. 1 corresponding to Comparative Example. This results from reduced variations in film quality of the i-type microcrystalline silicon film. As also seen from Fig. 6, nonuniformity is reduced significantly until a pressure difference between the upstream pressure $P_{in}$ and the downstream pressure $P_{out}$ of the second supplying parts 4b reaches 302 Pa. Thus, it was confirmed that supplying $H_2$ gas to the second supplying parts 4b under condition of $P_{in} - P_{out} \geq 302$ Pa controls nonuniformity at a low level, and that nonuniformity is corrected further with increase in pressure difference.

Example 2

Next, under the condition of No. 10 described in Example 1 showing corrected nonuniformity, the power generation efficiencies of thin-film solar cells were compared that were obtained by supplying $SiH_4$ gas only to the second supplying parts 4b (condition A), and by supplying $SiH_4$ gas only to the first supplying parts 4a (condition B: Comparative Example). Like in Example l, 16 thin-film solar cell elements of 1 cm $\times$ 1 cm were formed on a glass substrate of 10 cm $\times$ 10 cm under these conditions.

It was found that, while an initial power generation efficiency of from about 11 to 13% is obtained with good reproducibility under condition A, a power generation efficiency obtained under condition B is lower, which is only from about 9 to 12%. The reason therefor may be found in the fact that a resultant film quality is reduced under Condition B due to excessive decomposition of $SiH_4$ gas by hollow cathode discharge.

Thus, the effect achieved by supplying $SiH_4$ gas (second material gas) higher in decomposition rate than $H_2$ gas (first material gas) only to the second supplying parts 4b was confirmed.

Example 3

Next, comparison was made between dependency of a power generation efficiency on a film forming speed determined under condition A mentioned in Example 2 (condition that the heated catalyzer 11 was not provided in the introducing path 3a through which $H_2$ gas (first material gas) is introduced), and that determined under condition C that the heated catalyzer 11 was provided in the introducing path 3 a through which $H_2$ gas (first material gas) is introduced. Film forming speed was changed by increasing and reducing power for plasma production. The temperature of the heated catalyzer 11 was set at 1600°C under condition C.

As a result, it was found that, under condition A, a power generation efficiency is reduced as film forming speed gets closer to 1 nm/s, and is reduced significantly with the film forming speed of about 1 nm/s or higher. In contrast, it was found that a power generation efficiency is substantially the same under condition C even if film forming speed exceeds 1 nm/s. The reason therefor may be found in the fact that reaction of higher-order silane formation is suppressed in plasma space in the second space 9 as a result of gas heating effect achieved by the heated catalyzer 11. Further, more efficient production of atomic hydrogen may be a possible factor in maintaining the degree of crystallization without causing its reduction even under condition of high-speed film formation.

Thus, it was confirmed that a high-quality film is formed even under condition of higher-speed film formation by providing the heated catalyzer 11 in the $H_2$ gas (first material gas) introducing path 3a.

Reference Signs List

1 : Chamber

2 : Second electrode

4 : Supplying part

4a : First supplying part

4b : Second supplying part

6 : First electrode

8 : First space

9 : Second space

10 : Base

**Claims**

1. A deposited film forming device, comprising:

   a chamber:

   a first electrode arranged in the chamber; and
   a second electrode arranged in the chamber and spaced a certain distance from the first electrode, the second electrode including first and second supplying parts, the first supplying part supplying a first material gas and generating hollow cathode discharge, the second supplying part supplying a second material gas higher in decomposition rate than the first material gas.

2. The deposited film forming device according to claim 1, wherein the second supplying part does not generate hollow cathode discharge, or generates hollow cathode discharge of a magnitude smaller than that of hollow cathode discharge generated by the first supplying part.

3. The deposited film forming device according to claim 1 or 2, wherein the first supplying part includes a hollow portion in which the hollow cathode discharge is generated.

4. The deposited film forming device according to claim 3, wherein the hollow portion of the first supplying part becomes smaller in cross-sectional area with a greater distance from the first electrode.

5. The deposited film forming device according to any one of claims 1 to 4, wherein
   the second electrode includes a plurality of the first supplying parts, and
   a distance between two adjacent ones of the first supplying parts is smaller than a distance between the second electrode and a base, the base being placed between the first and second electrodes.

6. The deposited film forming device according to any one of claims 1 to 5, wherein the first material gas includes non-Si-based gas, and the second material gas includes Si-based gas.

7. The deposited film forming device according to claim 6, wherein the non-Si-based gas includes hydrogen gas.

8. The deposited film forming device according to claim 7, wherein the non-Si-based gas further includes methane gas.

9. The deposited film forming device according to any one of claims 1 to 8, wherein a heated catalyzer is provided in an introducing path through which the first material gas is introduced to the first supplying part.

10. A deposited film forming method, comprising:

a step of preparing a first electrode, a second electrode spaced a certain distance from the first electrode and including first and second supplying parts, and a base;
a step of placing the base between the first and second electrodes;
a step of generating hollow cathode discharge in a first space within the first supplying part;
a step of supplying a first material gas to the first space;
a step of activating the first material gas in the first space;
a step of supplying the activated first material gas from the first space toward the base;
a step of generating glow discharge in a second space between the first and second electrodes;
a step of supplying a second material gas higher in decomposition rate than the first material gas from the second supplying part toward the base; and
a step of activating the second material gas in the second space.

11. The deposited film forming method according to claim 10, further comprising a step of mixing the second material gas and the activated first material gas in the second space.

12. The deposited film forming method according to claim 10 or 11, wherein the second material gas is supplied only from the second supplying part.

13. The deposited film forming method according to any one of claims 10 to 12, wherein the first material gas is supplied only from the first supplying part.

14. The deposited film forming method according to any one of claims 10 to 13, further comprising a step of activating the first material gas in the second space.

15. The deposited film forming method according to any one of claims 10 to 14, further comprising:

a step of preparing a heated catalyzer in an introducing path through which the first material gas is introduced to the first supplying part;
a step of heating the heated catalyzer; and
a step of activating the first material gas with the heated catalyzer.

F I G . 1

( a )

( b )

FIG. 2

4a

4b

2

F I G . 3

（a）

（b）

F I G . 4

F I G . 5

F I G . 6

<table>
<tr><td colspan="2" align="center">**INTERNATIONAL SEARCH REPORT**</td><td colspan="2">International application No.<br>PCT/JP2009/063488</td></tr>
</table>

**A. CLASSIFICATION OF SUBJECT MATTER**
C23C16/50(2006.01)i, C23C16/455(2006.01)i, H01L21/205(2006.01)i, H01L31/04(2006.01)i

According to International Patent Classification (IPC) or to both national classification and IPC

**B. FIELDS SEARCHED**

Minimum documentation searched (classification system followed by classification symbols)
C23C16/50, C23C16/455, H01L21/205, H01L31/04

Documentation searched other than minimum documentation to the extent that such documents are included in the fields searched
| | | | |
|---|---|---|---|
| Jitsuyo Shinan Koho | 1922–1996 | Jitsuyo Shinan Toroku Koho | 1996–2009 |
| Kokai Jitsuyo Shinan Koho | 1971–2009 | Toroku Jitsuyo Shinan Koho | 1994–2009 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2004-056062 A (Kyocera Corp.),<br>19 February, 2004 (19.02.04),<br>Par. Nos. [0014] to [0015]; Fig. 11<br>(Family: none) | 1–15 |
| A | JP 2004-296526 A (National Institute of Advanced Industrial Science and Technology),<br>21 October, 2004 (21.10.04),<br>Par. Nos. [0008], [0020]<br>(Family: none) | 1–15 |
| A | JP 2002-280377 A (Hitachi Kokusai Electric Inc.),<br>27 September, 2002 (27.09.02),<br>Claims<br>(Family: none) | 1–15 |

☒ Further documents are listed in the continuation of Box C.　　　☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| | |
|---|---|
| Date of the actual completion of the international search<br>02 October, 2009 (02.10.09) | Date of mailing of the international search report<br>13 October, 2009 (13.10.09) |
| Name and mailing address of the ISA/<br>Japanese Patent Office | Authorized officer |
| Facsimile No. | Telephone No. |

Form PCT/ISA/210 (second sheet) (April 2007)

| INTERNATIONAL SEARCH REPORT | International application No. |
|---|---|
| | PCT/JP2009/063488 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2002-080968 A (Anelva Corp.), 22 March, 2002 (22.03.02), Claims; Fig. 4 & US 6427623 B2 | 1-15 |
| A | JP 2003-203873 A (Mitsubishi Heavy Industries, Ltd.), 18 July, 2003 (18.07.03), Full text (Family: none) | 1-15 |

Form PCT/ISA/210 (continuation of second sheet) (April 2007)

**EP 2 309 023 A1**

**REFERENCES CITED IN THE DESCRIPTION**

**Patent documents cited in the description**

- JP 2002237460 A